# EUROPÄISCHE PATENTSCHRIFT

(11) **EP 0 722 214 B1**
(45) Veröffentlichungstag und Bekanntmachung des Hinweises auf die Patenterteilung: **11.08.1999**
(21) Anmeldenummer: 96100473.6
(22) Anmeldetag: 15.01.1996
(51) Int. Cl.: H02P 6/12, H02P 6/14

(54) **Elektronisch kommutierter Motor**
Electronically commutated motor
Moteur à commutation électronique

(30) Priorität: 14.01.1995 DE 29500551 U
(43) Veröffentlichungstag der Anmeldung: 17.07.1996
(73) Patentinhaber: PAPST-MOTOREN GmbH & Co. KG, 78106 St Georgen (DE)
(72) Erfinder: Jeske, Frank, Dipl.-Ing., D-78144 Tennenbronn (DE)

(56) Entgegenhaltungen:
- DE-A- 3 537 403
- US-A- 4 385 265

## Beschreibung

Die Erfindung betrifft einen elektronisch kommutierten Motor, insbesondere zum Antrieb eines Lüfters mit variabler Drehzahl.

Aus der DE-A 3 537 403 kennt man einen kollektorlosen Gleichstrommotor zum Antrieb eines Lüfters mit variabler Drehzahl. Dieser Motor hat zwei Wicklungsstränge. Der Strom in jedem Wicklungsstrang wird durch ein zugeordnetes Halbleitersteuerglied gesteuert, welches eine Steuerelektrode und eine Ausgangselektrode aufweist. Ein temperaturabhängiger Widerstand im Luftstrom des Lüfters steuert den Strom in den beiden Halbleitersteuergliedern so, daß bei niedrigen Temperaturen der Motor langsamer läuft als bei hohen Temperaturen. Bei Drehzahlen in der Nähe der Höchstdrehzahl sollen die Leistungshalbleiter als Schalter betrieben werden.

Aus der US-A 4 385 265 ist es bei einem kollektorlosen Gleichstrommotor bekannt, die Flanken von rechteckförmigen Steuerimpulsen mittels RC-Gliedern zu verändern. Wenn der Strom im Motor ansteigt, wird durch eine Rückkopplung die Amplitude der Steuerimpulse erhöht, welche diesen RC-Gliedern zugeführt werden. Hierdurch soll vermieden werden, daß bei hohen Motorströmen der Motor zu laut wird.

Aufgabe der Erfindung ist es, einen neuen Motor der eingangs genannten Art bereitzustellen.

Nach der Erfindung wird diese Aufgabe gelöst durch einen elektronisch kommutierten Motor, insbesondere zum Antrieb eines Lüfters mit variabler Drehzahl, mit mindestens einem Wicklungsstrang und einem den Strom in diesem Wicklungsstrang steuernden Halbleitersteuerglied, welches eine Steuerelektrode und eine Ausgangselektrode aufweist, zwischen welchen die Serienschaltung eines Kondensators und eines Widerstands angeordnet ist, und mit von einem Betriebsparameter des Motors abhängigen Steuermitteln, welche einen Lade- oder Entladevorgang des Kondensators dieser Serienschaltung temperatur- und/oder drehzahlabhängig beeinflussen, um die Flankensteilheit an den Abschalfflanken der durch diesen Wicklungsstrang fließenden Stromimpulse so zu steuern, daß diese Flankensteilheit mit zunehmender Temperatur und/oder zunehmender Drehzahl zunimmt.

Dies ermöglicht es, bei niedriger Last den Motor mit flachen Abschalfflanken und folglich niedrigem Motorgeräusch zu betreiben, und bei hoher Last mit steilen Abschalfflanken, aber niedrigen elektrischen Verlusten in der zugehörigen elektronischen Schaltung, verbunden mit höheren Motorgeräuschen. Eine solche Anordnung wirkt praktisch als elektronische Sicherung für die Leistungshalbleiter, denn je steiler - bei hohen Temperaturen - die Abschalfflanken werden, umso geringer werden die elektrischen Verluste in diesen Leistungshalbleitern, und durch eine solche Anordnung werden folglich mit steigender Temperatur diese Verluste reduziert.

Nach einer vorteilhaften Weiterbildung der Erfindung sind bei einem solchen Motor die Steuermittel über eine Diode an den Kondensator der Serienschaltung angeschlossen, wobei man mit besonderem Vorteil so vorgeht, daß der Motor zwei Wicklungsstränge aufweist, denen jeweils ein Halbleitersteuerglied mit einer zwischen Steuerelektrode und Ausgangselektrode angeordneten Serienschaltung eines Kondensators und eines Widerstands zugeordnet ist, wobei die Steuermittel für beide Serienschaltungen gemeinsam sind und über eine erste Diode an den Kondensator der einen Serienschaltung und über eine zweite Diode an den Kondensator der anderen Serienschaltung angeschlossen sind. Dies ermöglicht einen extrem einfachen Aufbau einer solchen Anordnung.

Der Motor wird in diesem Fall mit besonderem Vorteil als zweisträngiger, zweipulsiger Motor mit Reluktanz-Hilfsmoment ausgebildet, da dies ebenfalls eine sehr preiswerte Ausbildung ermöglicht.

Eine sehr einfache Anordnung ergibt sich dann, wenn die Steuermittel einen temperaturabhängigen Widerstand aufweisen. Dabei geht man mit großem Vorteil so vor, daß Widerstandswerte des temperaturabhängigen Widerstands, welche außerhalb eines vorgegebenenWertebereichs liegen, keinen zusätzlichen Einfluß auf Flankensteilheit und/oder Drehzahl des Motors haben. Dies ist besonders vorteilhaft bei niedrigen Temperaturen, bei denen z.B. ein NTC-Widerstand sehr hohe Widerstandswerte annehmen kann, die dann bei einem temperaturgesteuerten Motor zu sehr niedrigen Drehzahlen führen könnten, was unerwünscht wäre. Ebenso wäre eine zu geringe Flankensteilheit der Abschalfflanken unerwünscht, da sie keine weitere Geräuschminderung bringt, aber den Wirkungsgrad des Motors verschlechtern würde.

Eine andere Lösung der gestellten Aufgabe ergibt sich durch den Gegenstand der Ansprüche 12 und 14. Da nämlich die hier verwendeten temperaturabhängigen Widerstände häufig außerhalb des Motors angeordnet werden, z.B. in der Nähe des Netzteils eines Computers, besteht immer die Gefahr, daß die Zuleitung zu einem solchen Widerstand unterbrochen wird. Ist dies ein NTC-Widerstand, so hat dies zur Folge, daß ein Signal erzeugt wird, welches einer sehr tiefen Temperatur entsprechen würde, d.h. ein Lüfter würde in diesem Fall sehr langsam rotieren, auch wenn die Temperatur, z.B. in einem Computer, sehr hoch wird. Durch den Gegenstand der Ansprüche 12 und 14 wird erreicht, daß ein Motor in einem solchen Fall automatisch auf eine hohe Drehzahl umgeschaltet wird, so daß auch bei einem solchen Leitungsbruch keine Schäden durch Überhitzung entstehen können. Durch die ständige hohe Drehzahl wird der Benutzer in diesem Fall schnell auf den Schaden aufmerksam und kann den Lüfter reparieren oder ersetzen.

Eine andere Lösung der gestellten Aufgabe ergibt sich durch den Gegenstand des Patentanspruchs 15. Man erreicht so, daß bei starker Belastung der Leistungshalbleiter die Abschalfflanken der Ströme in diesen Leistungshalbleitern steiler werden, wodurch diese Leistungshalbleiter thermisch weniger stark belastet werden.

Weitere Einzelheiten und vorteilhafte Weiterbildungen der Erfindung ergeben sich aus den im folgenden beschriebenen und in der Zeichnung dargestellten, in keiner Weise als Einschränkung der Erfindung zu verstehenden Ausführungsbeispielen, sowie aus den Unteransprüchen. Es zeigt:
Fig. 1 ein Schaltbild eines zweipulsigen elektronisch kommutierten Motors bekannter Bauart, bei dem Maßnahmen zur Geräuschminderung getroffen sind,
Fig. 2 eine Darstellung eines typischen Gerätelüfters, dessen Motor die Schaltung nach Fig. 1, oder eine der nachfolgend dargestellten und beschriebenen Schaltungen, aufweisen kann,
Fig. 3 Schaubilder zur Erläuterung der Fig. 1,
Fig. 4 ein Schaltbild einer erfindungsgemäßen Ausführungsform eines elektronisch kommutierten Motors, bei dem Maßnahmen zur Geräuschminderung getroffen sind, die bei hoher Belastung des Motors automatisch außer Funktion gesetzt werden, um die Endstufentransistoren zu schützen,
Fig. 5 Schaubilder zur Erläuterung der Fig. 4,
Fig. 6 ein Schaltbild einer bevorzugten Variante zu Fig. 4,
Fig. 7 ein Prinzipschaltbild zur Erläuterung des Grundprinzips der Erfindung in seiner Anwendung auf einen Motor, bei dem die Drehzahl von der Temperatur an einem temperaturabhängigen Widerstand 84 gesteuert wird,
Fig. 8 ein ausführliches Schaltbild analog Fig. 7 für einen Motor, dessen Drehzahl abhängig von der Temperatur an einem temperaturabhängigen Widerstand 84 ist, wobei besondere geräuschdämpfende Maßnahmen beiniedrigen Drehzahlen getroffen sind,
Fig. 9 eine Darstellung des prinzipiellen Aufbaus eines IC, wie er bei der Schaltung nach Fig. 8 verwendet werden kann,
Fig. 10 Schaubilder zur Erläuterung der Schaltung nach Fig. 8, und
Fig. 11 ein Diagramm zur Erläuterung der Schaltung nach Fig. 8.

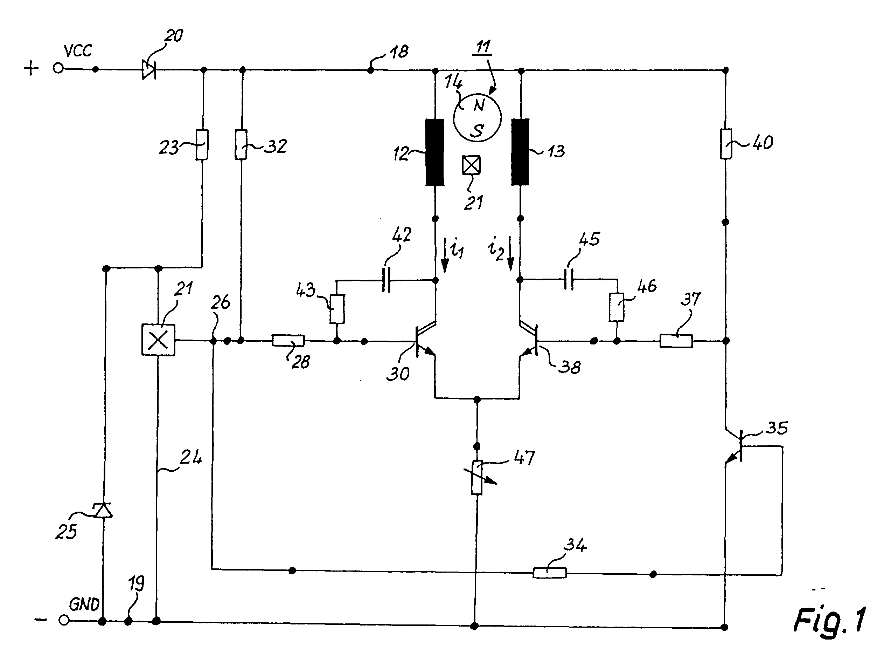

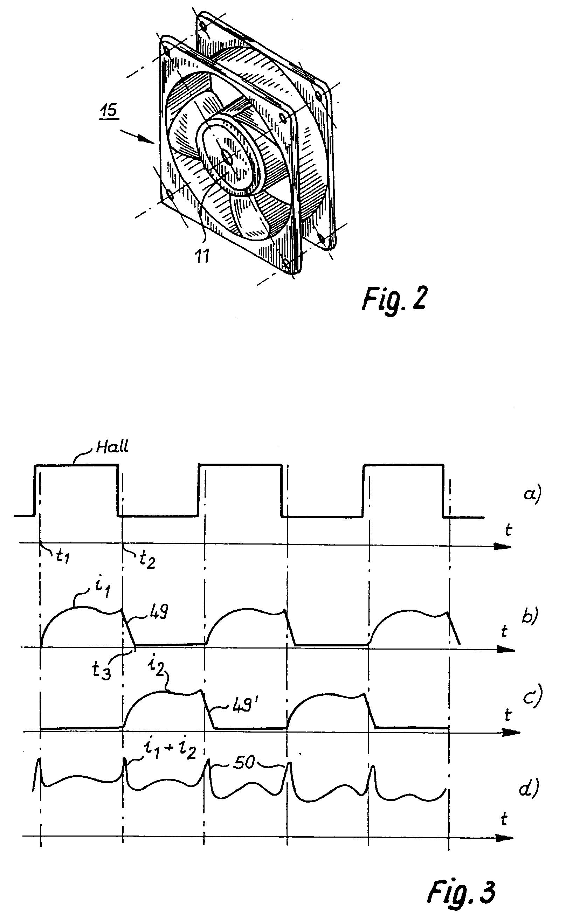

Das Schaltbild nach Fig. 1 zeigt eine Schaltung für einen sogenannten zweipulsigen, zweisträngigen elektronisch kommutierten Motor (im folgenden: ECM) 11, der zwei Wicklungsstränge 12, 13 und einen nur symbolisch angedeuteten permanentmagnetischen Rotor 14 hat. Gemäß Fig. 2 kann dieser Motor 11 in der Nabe eines Gerätelüfters 15 angeordnet sein und zu dessen Antrieb dienen. Der Antrieb erfolgt oft mit variabler Drehzahl. Wenn die Temperatur des zu kühlenden Geräts niedrig ist, kann der Lüfter 15 mit niedriger Drehzahl laufen. Ist sie hoch, so muß auch die Drehzahl hoch sein.

Zu den Begriffen "zweipulsig" und "zweisträngig" wird verwiesen auf den Aufsatz von Müller in "asr - digest für angewandte Antriebstechnik, Heft 1/2, 1977, 27-31. Dort sind diese Begriffe definiert. Die Erfindung eignet sich naturgemäß besonders auch für einsträngige, zweipulsige Motoren, und die Erfindung gemäß Anspruch 1 kann mit großem Vorteil auch bei einpulsigen Motoren angewendet werden. Die Erfindung eignet sich ebenfalls für Motoren mit höheren Pulszahlen (dreipulsig, etc.) und höheren Strangzahlen, und ermöglicht dort ebenfalls eine Geräuschminderung bei niedrigen Drehzahlen, ohne die Leistung bei hohen Drehzahlen zu beeinträchtigen.

Bei niedrigen Drehzahlen soll ein Lüfter so leise laufen, daß man von ihm nur ein leises Säuseln hört. Motorgeräusche müssen deshalb strikt vermieden werden. Bei hohen Drehzahlen ist ein Lüfter immer laut, und in diesem Fall stören Motorgeräusche (Körperschall des Motors) nicht, da sie im Lüftergeräusch, also dem sogenannten Luftschall, untergehen.

Beim Motor nach den Fig. 1 und 2 kann die Drehzahl dadurch erhöht werden, daß man die Spannung V_{CC} zwischen einer Plusleitung 18 und einer Minusleitung 19 erhöht. Wie bei jedem Gleichstrommotor nimmt dann die Drehzahl zu, und der Lüfter 15 läuft entsprechend schneller und transportiert mehr Luft.

In der Plusleitung 18 ist eine Diode 20 angeordnet, welche den Motor 11 gegen falsch gepolten Anschluß schützt. In der Nähe des Rotors 14 ist als Rotorstellungssensor ein Hall-IC 21 angeordnet, der in Fig. 1 auch auf der linken Seite nochmals dargestellt ist. Sein einer Stromanschluß ist über einen Widerstand 23 mit der Plusleitung 18 verbunden, sein anderer Stromanschluß über eine Leitung 24 mit der Minusleitung 19. Parallel zu ihm liegt eine Zenerdiode 25, welche die Spannung an ihm konstant hält, z.B. auf 5 V.

Der Signalausgang 26 des Hall-IC 21 ist über einen Widerstand 28 mit der Basis eines npn-Darlingtontransistors 30 verbunden, ferner über einen Widerstand 32 mit der Plusleitung 18, und über einen Widerstand 34 mit der Basis eines Phasenumkehrtransistors 35 (npn), dessen Emitter mit der Minusleitung 19 und dessen Kollektor über einen Widerstand 37 mit der Basis eines npn-Darlingtontransistors 38 und über einen Widerstand 40 mit der Plusleitung 18 verbunden ist.

Parallel zur Basis-Kollektor-Strecke des Transistors 30 liegt eine RC-Serienschaltung aus einem Kondensator 42 und einem Widerstand 43. Ebenso liegt parallel zur Basis-Kollektor-Strecke des Transistors 38 eine RC-Serienschaltung aus einem Kondensator 45 und einem Widerstand 46. Der Kollektor des Transistors 30 ist mit dem einen Anschluß des Wicklungsstranges 12 verbunden, dessen anderer Anschluß an der Plusleitung 18 liegt. Der Kollektor des Transistors 38 ist mit dem einen Anschluß des Wicklungsstranges 13 verbunden, dessen anderer Anschluß ebenfalls an der Plusleitung 18 liegt. Die Emitter der Transistoren 30 und 38 sind über einen gemeinsamen Emitterwiderstand 47 (PTC-Widerstand, der als Sicherung dient) mit der Minusleitung 19 verbunden. In manchen Fällen können die Widerstände 43 und 46 sehr kleine Widerstandswerte haben, oder auch den Widerstandswert Null.

### Arbeitsweise

Wie die Fig. 3a und 3b zeigen, wird der Transistor 30 zum Zeitpunkt t₁ mit einer kleinen zeitlicher Verzögerung (durch das RC-Glied 43, 42) eingeschaltet, wenn das Signal Hall am Signalausgang 26 hoch wird. Ebenso wird der Transistor 35 eingeschaltet, wodurch der Transistor 38 gesperrt wird.

Es sei nun angenommen, daß der Motor mit hoher Spannung, also hoher Drehzahl, betrieben wird, so daß der Strom i₁ durch den Strang 12 eine hohe Amplitude hat. Wird das Hallsignal zum Zeitpunkt t₂ negativer, so wird der Transistor 30 abgeschaltet, und diese Abschaltung erfolgt mit einer relativ flachen Abschaltflanke 49, vgl. Fig. 3b, da sich hierbei der zuvor geladene Kondensator 42 über die Basis des Transistors 30 entlädt. Diese Abschaltverzögerung dauert bis zum Zeitpunkt t₃.

Gleichzeitig wird der Transistor 35 gesperrt, wodurch der Transistor 38 zum Zeitpunkt t₂ leitend wird, und der Strom i₂ durch den Strang 13 wird eingeschaltet, d.h. im Zeitraum zwischen t₂ und t₃ fließen beide Ströme i₁ und i₂ gleichzeitig. Auf der Zuleitung zum Motor 11 ergeben sich dadurch die in Fig. 3d dargestellten Stromspikes 50. Diese erzeugen störende Motorgeräusche in Form von Körperschall, und der Wirkungsgrad des Motors 11 wird verschlechtert, da diese Stromspikes 50 vergeudete Energie darstellen. Außerdem werden durch die flachen Abschaltflanken 49, 49' (bei i₂) die Transistoren 30 und 38 gerade bei der maximalen Motorleistung zusätzlich erwärmt, was sehr unerwünscht ist, da es die Leistung dieser Transistoren reduziert und ihre Lebensdauer verkürzt.

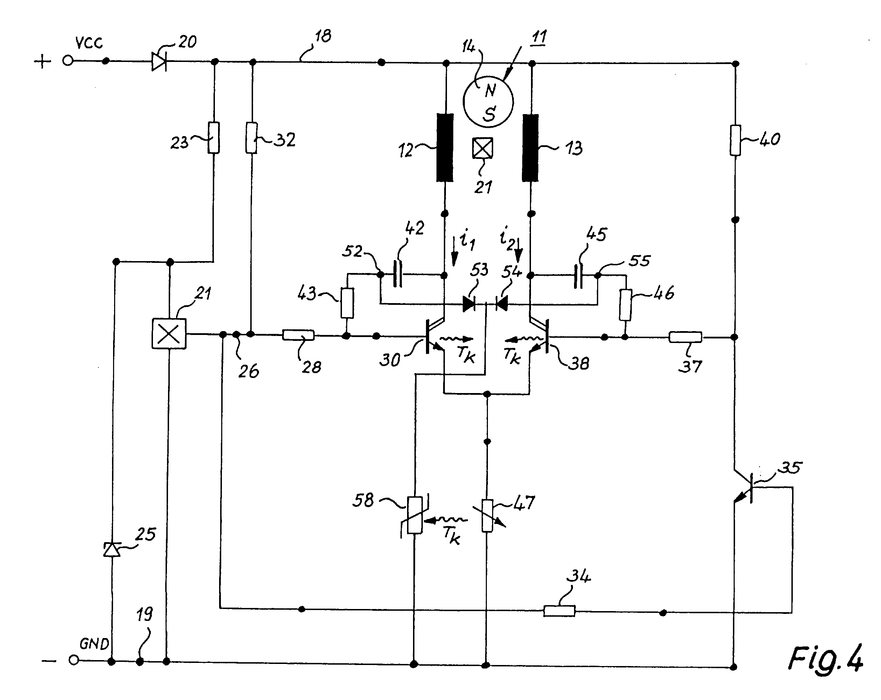

Fig. 4 zeigt eine Schaltung, welche zu großen Teilen mit Fig. 1 übereinstimmt, weshalb dieselben Bezugszeichen verwendet werden wie dort, und die übereinstimmenden Elemente werden nicht nochmals erläutert. Die Schaltung gemäß Fig. 4 enthält drei zusätzliche Schaltelemente, und diese bewirken, daß bei hoher Drehzahl des Motors und starker Belastung der Endstufentransistoren 30, 38 die Abschaltflanken der Ströme i₁ und i₂ zunehmend steiler werden.

Hierzu ist an den Verbindungspunkten 52 des Kondensators 42 und des Widerstands 43 die Anode einer Diode 53 angeschlossen, deren Katode mit der Katode einer Diode 54 verbunden ist, deren Anode mit dem Verbindungspunkt 55 zwischen dem Kondensator 45 und dem Widerstand 46 verbunden ist. Die Katoden der Dioden 53 und 54 sind über einen NTC-Widerstand 58 mit der Minusleitung 19 verbunden. (Der Widerstand eines NTC-Widerstands nimmt umsomehr ab, je höher die Temperatur dieses Widerstands wird.)

Wie in Fig. 4 symbolisch durch gewellte Pfeile angedeutet, besteht eine thermische Kopplung Tₖ zwischen den Transistoren 30 und 38 und dem NTC-Widerstand 58. Dies kann z.B. dadurch erreicht werden, daß alle drei Bauteile mit derselben Wärmesenke verbunden sind.

### Arbeitsweise

Solange der Motor 11 kalt ist und die Transistoren 30 und 38 folglich eine niedrige Temperatur haben, stimmt die Arbeitsweise der Schaltung mit derjenigen nach Fig. 1 überein, d.h. durch die beiden RC-Glieder 42, 43 bzw. 45, 46 werden flache Abschaltflanken 49, 49' erzeugt, wie in Fig. 3b und Fig. 3c dargestellt. Dies ist z.B. dann der Fall, wenn der Motor 11 mit niedriger Spannung und folglich niedriger Drehzahl betrieben wird. Dabei hat der NTC-Widerstand 58 einen hohen Widerstandswert, so daß er die Funktion der Schaltung praktisch nicht beeinflußt.

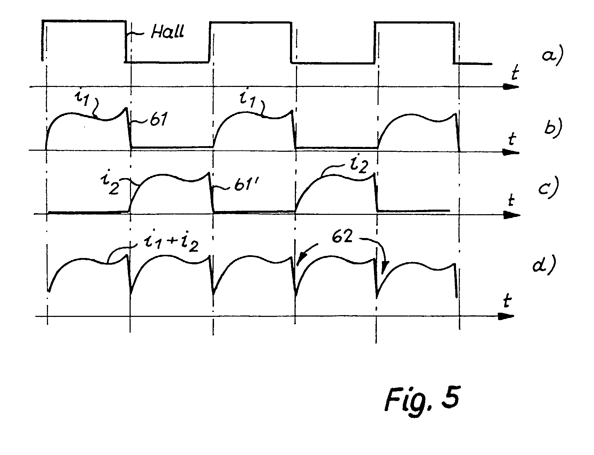

Steigt jedoch durch die Belastung der Transistoren 30 und 38 bei hoher Betriebsspannung und folglich hoher Drehzahl die Temperatur der Transistoren 30 und 38 an, so wird diese erhöhte Temperatur durch die thermische Kopplung Tₖ auf den NTC-Widerstand 58 übertragen, und dessen Widerstandswert nimmt ab. Beim Abschalten eines Transistors 30 oder 38 wirkt der Widerstand 58 jetzt als zusätzlicher Basisableitwiderstand für diese Transistoren, also als Stromsenke, wodurch die Kondensatoren 42 bzw. 45 beim Abschaltvorgang schneller entladen werden und folglich die Abschaltflanken 61 (Fig. 5b) bzw. 61' (Fig. 5c) wesentlich steiler werden, d.h. die Ströme i₁ und i₂ überlappen sich im Bereich der Kommutierung praktisch nicht mehr, und statt der Stromspikes 50 (Fig. 3d) erhält man jetzt im Kommutierungsbereich die gewünschten Stromlücken 62, wie in Fig. 5d dargestellt.

Außerdem werden durch die steilen Abschaltflanken 61, 61' die Transistoren 30 bzw. 38 thermisch wesentlich weniger belastet, d.h. die Anordnung gemäß Fig. 4 wirkt wie eine thermische Sicherung für die Transistoren 30 und 38.

Der große Vorteil der Schaltung nach Fig. 4 ist also, daß diese sich selbsttätig auf die Umgebungs- und Lastbedingungen des Motors 11 einstellt, d.h. bei niedriger Last und folglich niedriger Temperatur der Transistoren 30 und 38 sind die Abschaltflanken 61, 61' flach und der Motor 11 läuft leise und ohne Motorgeräusche. Dagegen sind bei hohen Temperaturen der Transistoren 30 und 38 die Abschaltflanken 61, 61' steil, wodurch zwar die Motorgeräusche zunehmen, aber die thermische Belastung der Transistoren 30 und 38 automatisch reduziert wird, was deren Lebensdauer, und damit die Lebensdauer des Motors 11, markant erhöht.

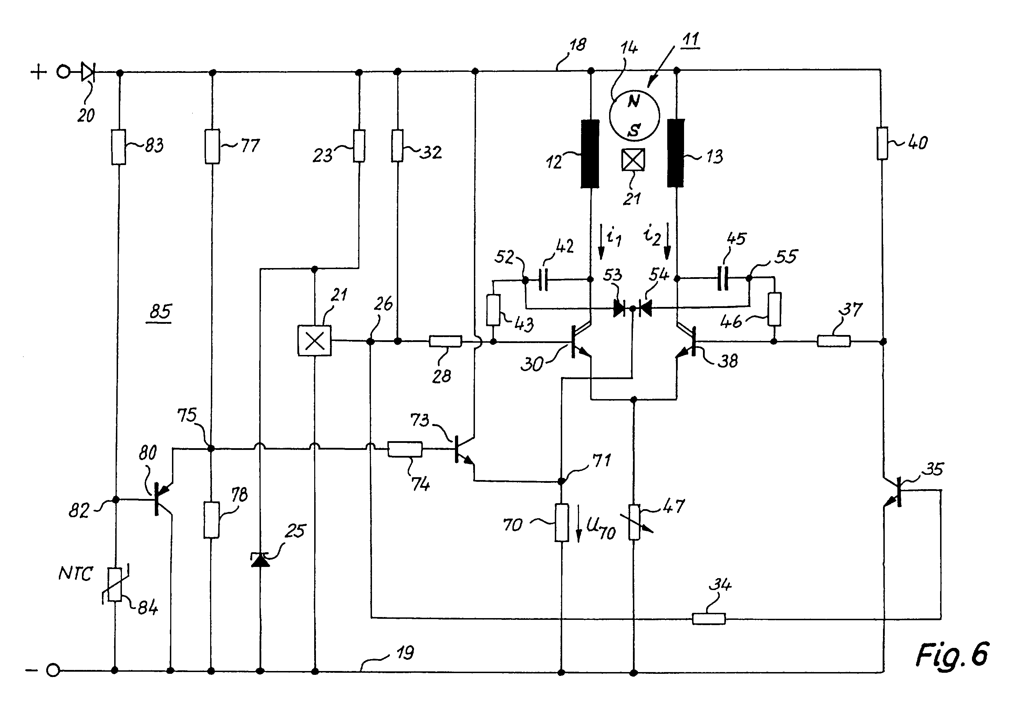

Fig. 6 zeigt eine Variante zu Fig. 4. Gleiche oder gleichwirkende Teile in den Fig. 1 und 4 werden deshalb mit denselben Bezugszeichen bezeichnet wie dort und gewöhnlich nicht nochmals beschrieben. Der NTC-Widerstand 58 der Fig. 4 ist hier ersetzt durch einen Widerstand 70 mit festem Widerstandswert. Sein mit den Dioden 53, 54 verbundener Anschluß 71 wirkt als Stromsenke mit variablem Potential für die Entladung der Kondensatoren 42 und 45. Der Anschluß 71 ist verbunden mit dem Emitter eines npn-Transistors 73, der in Emitterfolgerschaltung geschaltet ist und dessen Kollektor direkt mit der Plusleitung 18 verbunden ist. Seine Basis ist über einen Widerstand 74 verbunden mit einem Knotenpunkt 75, der über einen Widerstand 77 mit der Plusleitung 18 und über einen Widerstand 78 mit der Minusleitung 19 verbunden ist. An den Knotenpunkt 75 ist auch der Emitter eines pnp-Transistors 80 angeschlossen, dessen Kollektor an die Minusleitung 19 angeschlossen ist. Seine Basis ist an einen Knotenpunkt 82 angeschlossen, der über einen Widerstand 83 mit der Plusleitung 18 und über einen NTC-Widerstand 84 mit der Minusleitung 19 verbunden ist.

Wie man ohne weiteres erkennt, bilden die vier Widerstände 77, 78, 83, 84 eine Brückenschaltung 85, in deren Diagonale, nämlich zwischen den Knotenpunkten 75 und 82, die Basis-Emitter-Strecke des Transistors 80 angeordnet ist. Ist der Knotenpunkt 82 positiver als der Knotenpunkt 75, so leitet der Transistor 80 mehr oder weniger stark, entsprechend der Potentialdifferenz, und wirkt dadurch als Parallelwiderstand zum Widerstand 78 der Brücke 85, wodurch das Potential des Knotenpunkts 75 abgesenkt wird. Dies ist dann der Fall, wenn der NTC-Widerstand 84 erwärmt ist, da dann der Widerstandswert dieses Widerstands 84 abnimmt. Der Transistor 80 dient also in diesem Fall dazu, die Brücke 85 ungefähr in einen abgeglichenen Zustand zu bringen, d.h. wenn bei steigender Temperatur der Widerstand 84 kleiner wird, bekommt auch die Parallelschaltung aus Widerstand 78 und Transistor 80 einen niedrigeren Widerstandswert, so daß die Spannung an ihr abnimmt.

Wird hierbei das Potential des Knotenpunkts 75 abgesenkt, so wird das Potential an der Basis des Transistors 73 weniger positiv, d.h. der Strom durch den Transistor 73 nimmt ab, und die Spannung u₇₀ am Widerstand 70 nimmt folglich ebenfalls ab. Dadurch kann über die Dioden 53, 54 ein stärkerer Entladestrom von den Kondensatoren 42 bzw. 45 zum Widerstand 70 fließen, und zwar umso mehr, je wärmer der NTC-Widerstand 84 wird, da dann die Spannung u₇₀ immer kleiner wird. Dies hat zur Folge,daß die Steigung der Abschaltflanken (61, 61' in Fig. 5b bzw. Fig. 5c) mit steigender Temperatur des NTC-Widerstands 84 immer größer wird, d.h. die Steilheit der Abschaltflanken 61, 61' nimmt mit steigender Temperatur des NTC-Widerstands 84 immer mehr zu, wodurch die Verlustleistung in den Transistoren 30, 38 entsprechend reduziert wird.

Nimmt umgekehrt die Temperatur des NTC-Widerstands 84 ab, so werden die Abschaltflanken 61, 61' flacher, weil der Transistor 80 immer weniger leitend wird, folglich das Potential des Knotenpunkts 75 immer positiver wird, und folglich der Emitterfolger-Transistor 73 immer stärker leitend wird, so daß die Spannung u₇₀ am Widerstand 70 immer mehr ansteigt und über die Dioden 53, 54 ein immer kleinerer Entladestrom von den Kondensatoren 42 bzw. 45 fließt, so daß die Entladung dieser Kondensatoren länger dauert und folglich die Abschaltflanken immer flacher werden. Der Punkt 71 wirkt also hier als Stromsenke mit variablem Potential.

Wenn die Knotenpunkte 75 und 82 dasselbe Potential haben, oder wenn das Potential des Knotenpunkts 82 positiver wird als das Potential des Knotenpunkts 75, so sperrt der Transistor 80. Dies ist also dann der Fall, wenn der NTC-Widerstand 84 sehr kalt ist und deshalb einen hohen Widerstandswert hat. In diesem Fall nimmt der Knotenpunkt 75 etwa das Potential an, das durch das Spannungsteilerverhältnis der Widerstände 77, 78 gegeben ist, d.h. der Anstieg des Potentials am Knotenpunkt 75 ist auf einen vorgegebenen Maximalwert begrenzt, z.B. auf + 4 V. Höher kann die Spannung am Knotenpunkt 75 nicht steigen. Dadurch wird verhindert, daß die Abschaltflanken 61, 61' (Fig. 5) bei sehr niedrigen Temperaturen zu flach werden. Man erhält so eine Begrenzung für die Abflachung der Abschaltflanken bei niedriger Temperatur.

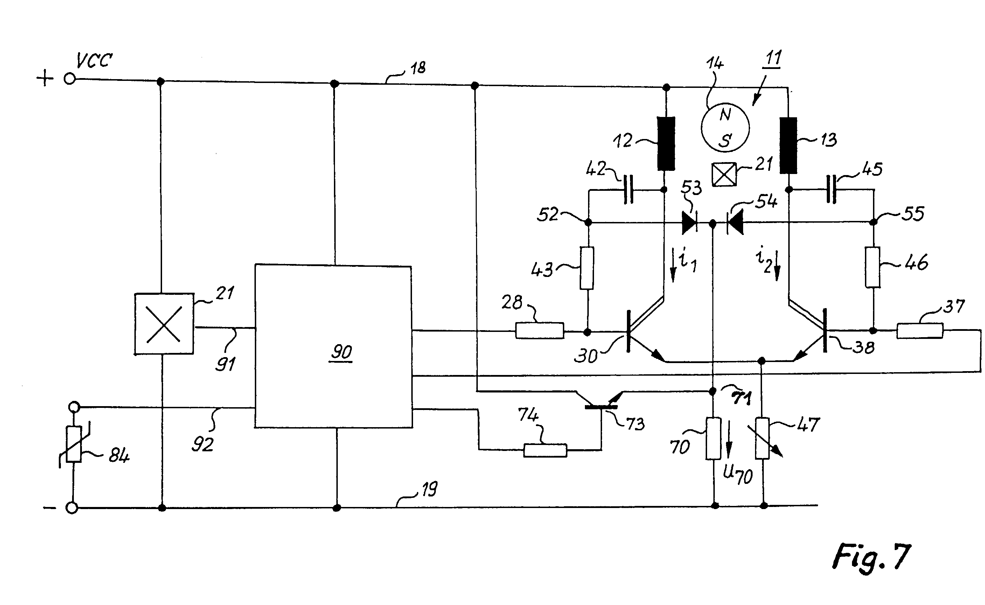

Der NTC-Widerstand 84 kann - wie bei Fig. 4 - in thermischem Kontakt mit den Transistoren 30 und/oder 38 stehen, um deren Temperatur abzufühlen. Er kann aber auch z.B. an einer heißen Stelle eines - nicht dargestellten - Geräts angeordnet sein, das von dem Lüfter 15 gekühlt wird, welcher vom Motor 11 angetrieben wird. Diese heiße Stelle kann z.B. das Netzteil eines Computers sein, und der NTC-Widerstand 84 wird dann in der Nähe dieses Netzteils angeordnet, um dessen Temperatur zu erfassen. Dieser Widerstand 84 kann auch zusätzlich dazu dienen, die Drehzahl des Motors 11 zu steuern, so daß dieser bei hohen Temperaturen schneller läuft als bei niedrigen. Diese Eigenschaft ist sehr nützlich bei Lüftern 15, welche zur Belüftung von Computern dienen. Dies wird anhand der nachfolgenden Fig. 7 erläutert.

Fig. 7 zeigt in stark schematisierter Form eine Schaltung mit einem Motor 11, der bei erhöhter Temperatur an einem NTC-Widerstand 84 schneller läuft. Gleiche oder gleichwirkende Teile wie in Fig. 1, Fig. 4 und Fig. 6 werden deshalb mit denselben Bezugszeichen bezeichnet wie dort und nicht nochmals beschrieben.

Zur Steuerung der Kommutierung der beiden Transistoren 30 und 38 ist hier eine Vorrichtung 90 vorgesehen, welche den Phasenumkehrtransistor 35 enthält und deren Eingang 91 Signale von einem Hall-IC 21 zugeführt werden. Ferner wird einem anderen Eingang 92 der Vorrichtung 90 ein Temperatursignal von dem NTC-Widerstand 84 zugeführt. Dieses Temperatursignal bewirkt eine solche Steuerung der Transistoren 30 und 38, daß der Motor 11 bei höheren Temperaturen schneller läuft als bei niedrigen. Ferner kann dieses Temperatursignal in der gleichen Weise, wie bei Fig. 6 ausführlich beschrieben, zur Steuerung der Spannung u₇₀ am Widerstand 70 verwendet werden, um die Flankensteilheit der Abschaltflanken bei den Stromimpulsen i₁, i₂ abhängig von der Temperatur zu steuern.

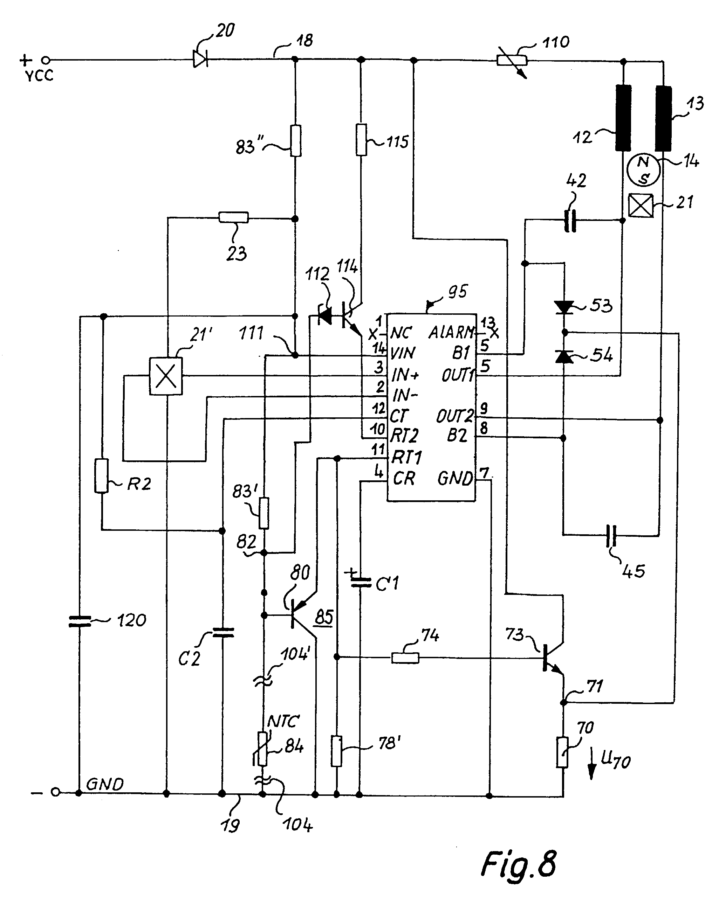

Die Schaltung nach Fig. 8 zeigt eine praktische Ausführungsform der Prinzipschaltung gemäß Fig. 7. Der Aufbau dieser Schaltung gemäß Fig. 8 ist ähnlich demjenigen nach Fig. 6, und deshalb werden für gleiche oder gleichwirkende Teile wie in Fig. 6 dieselben Bezugszeichen verwendet und gewöhnlich nicht nochmals beschrieben.

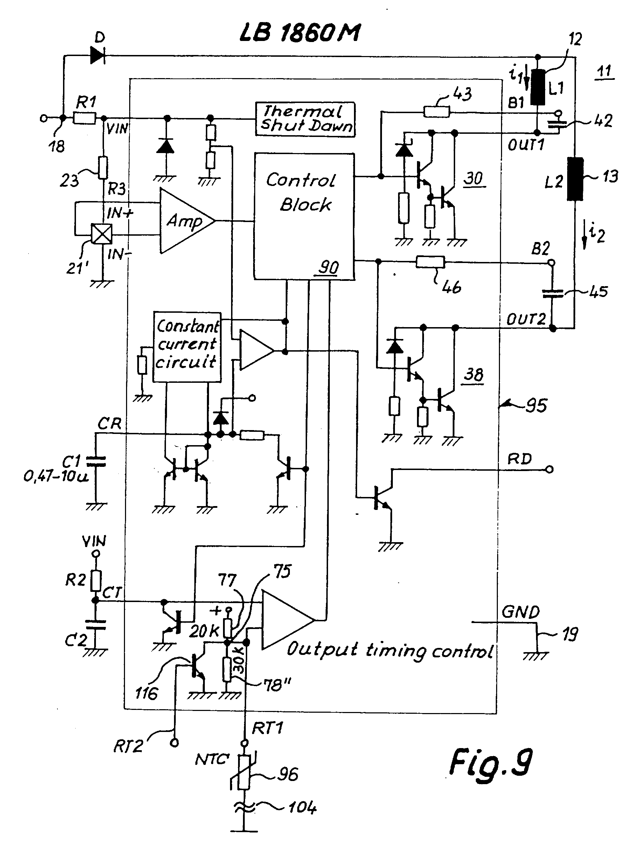

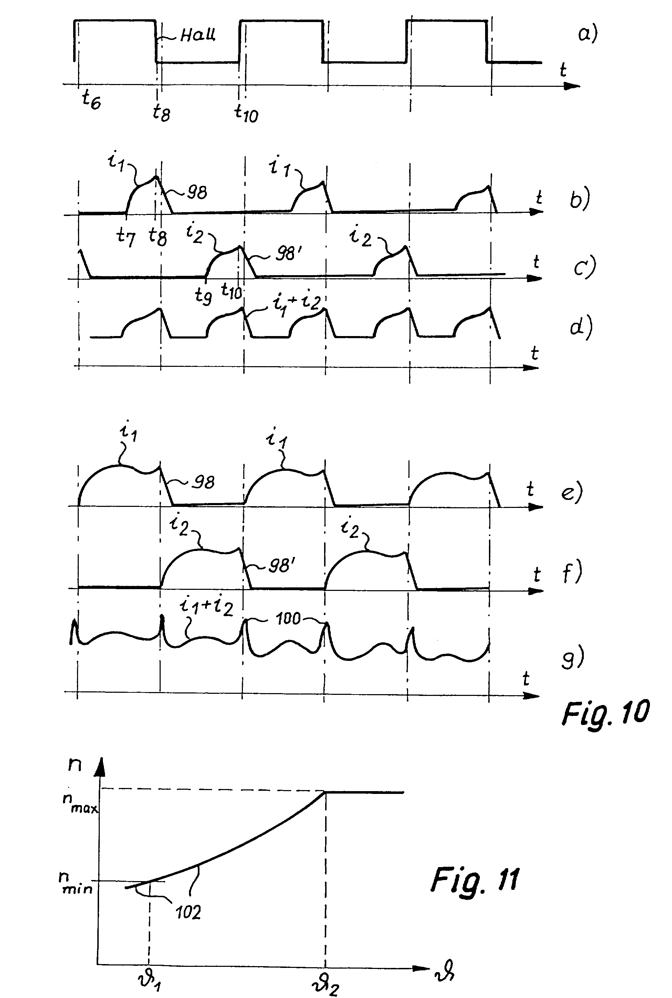

Die Schaltung nach Fig. 8 wird erläutert am Beispiel eines mit 95 bezeichneten IC der Firma Sanyo mit der Typenbezeichnung LB1860M. Dies ist ein handelsüblicher IC, weshalb auf die zugehörigen Datenblätter verwiesen werden kann. Fig. 9 zeigt den prinzipiellen Innenaufbau gemäß Datenblatt, Fig. 10 zugehörige Stromkurven, und Fig. 11 den zugehörigen Verlauf der Drehzahl n über der Temperatur theta.

Der IC 95 enthält - integriert - einen Teil der Bauelemente der Fig. 7, nämlich die beiden Darlingtontransistoren 30 und 38, den diese steuernden Kommutierungsbaustein 90, und die Widerstände 28, 37, 43 und 46, wobei die Widerstände 43 und 46an Anschlüsse B1 und B2 herausgeführt sind, so daß dort die Kondensatoren 42 bzw. 45 in der dargestellten Weise angeschlossen werden können. Durch die RC-Serienschaltungen 43, 42 bzw. 46, 45 können in der bereits beschriebenen Weise die Abschaltflanken der Stromimpulse i₁, i₂ flacher gemacht werden, um das Motorgeräusch zu reduzieren.

Der IC 95 hat insgesamt 14 Anschlüsse, die mit Bezeichnungen versehen sind wie RT1, RT2 etc., und dieselben Bezeichnungen werden auch in Fig. 8 verwendet. Diese Bezeichnungen werden deshalb nicht gesondert beschrieben.

Beim IC 95 kann, wie in Fig. 9 dargestellt, ein NTC-Widerstand 96 zwischen den Eingang RT1 und die Minusleitung 19 angeschlossen werden und steuert dann die Drehzahl des Motors 11 abhängig von der Temperatur am NTC-Widerstand 96. Dies wird anhand von Fig. 10 erläutert. Diese zeigt, ebenso wie die Fig. 2 und 5, in Reihe a) das Signal Hall an einem der Ausgänge des Hallgenerators 21' der Fig. 9.

Bei niedriger Temperatur am NTC-Widerstand 96 werden die Stromimpulse i₁ durch die Motorwicklung 12 erst ziemlich lange nach dem Zeitpunkt t₆ eingeschaltet, an dem das Signal Hall positiv wird, nämlich zum Zeitpunkt t₇. Diese Stromimpulse i₁ werden zu einem Zeitpunkt t₈ wieder abgeschaltet, an dem das Hallsignal wieder negativ wird, und durch das RC-Glied 43, 42 wird die Abschaltung verzögert, so daß sich eine Abschaltflanke 98 mit flachem Verlauf ergibt.

Die Stromimpulse i₂ durch die Motorwicklung 13 werden in analoger Weise zu einem Zeitpunkt t₉ eingeschaltet, der gegenüber dem Zeitpunkt t₈ erheblich verzögert ist, und sie werden abgeschaltet zu einem Zeitpunkt t₁₀, an welchem das Signal Hall wieder positiv wird, wobei auch hier durch das RC-Glied 46, 45 eine sanfte Abschaltung mit einer wenig steilen Abschaltflanke 98' erreicht wird.

Wird die Temperatur am NTC-Widerstand 96 höher, so werden die Stromimpulse i₁ und i₂ entsprechend früher eingeschaltet und dadurch länger.

Die Kurven in Fig. 10e, f und g zeigen die Stromimpulse i₁ und i₂ bei der maximalen Drehzahl nₘₐₓ der Fig. 11. Da hier die RC-Glieder 43, 42 bzw. 46, 45 in gleicher Weise wirksam sind, erhält man auch in diesem Fall die flachen Abschaltflanken 98, 98', was zu einer Überlappung der Stromimpulse i₁ und i₂ führt. Dadurch wird die maximal mögliche Drehzahl nₘₐₓ reduziert, und es entstehen Verluste durch Stromspikes 100, die jeweils bei der Kommutierung auftreten, vgl.Fig. 10g.

Deshalb ist man in der Praxis gezwungen, bei dem IC 95 die Kondensatoren 42 und 45 wegzulassen, und dadurch entstehen bei niedrigen Drehzahlen störende Motorgeräusche, weil die Abschaltflanken 98 in Fig. 10b und 98' in Fig. 10c sehr steil werden, was zu magnetostriktiven Geräuschen im Motor 11 und zu Körperschall führt.

Ein weiteres Problem beim IC 95 ist, daß bei sehr niedrigen Temperaturen, z.B. im Winter in einem nicht geheizten Zimmer, die Drehzahl n des Motors 11 sehr niedrig wird, wie in Fig. 11 durch die Kurve 102 angedeutet. Im allgemeinen wäre es erwünscht, diese Drehzahl nicht zu tief werden zu lassen, also einen unteren Grenzwert festzulegen, den die Drehzahl nicht unterschreiten kann. - Ein weiterer Nachteil liegt darin, daß bei einer Unterbrechung der Zuleitungen zum NTC-Widerstand 96, z.B. an der Stelle 104 (Fig. 9), die Drehzahl des Motors 11 ihren kleinsten möglichen Wert annimmt, auch bei sehr hohen Temperaturen. Gewünscht wird aber vielfach, daß in einem solchen Fall der Motor 11 mit seiner maximalen Drehzahl läuft, damit eine sichere Kühlung unter allen Umständen gewährleistet ist.

Fig. 8 zeigt eine Schaltung, welche hier eine wesentliche Verbesserung bringt: Die Motorgeräusche bei niedrigen Drehzahlen sind niedrig, weil die Abschaltflanken 98, 98' in Fig. 10b und 10c wenig steil sind. Dagegen sind die Abschaltflanken bei hohen Drehzahlen steil, so, wie in den Fig. 5b und 5c dargestellt, dort Flanken 60 und 61. Die Motordrehzahl n ist bei sehr niedrigen Temperaturen nach unten begrenzt auf einen Wert nₘᵢₙ, der nicht unterschritten werden kann. Und wenn die Zuleitung zum NTC-Widerstand 84 unterbrochen wird, z.B. an der Stelle 104 oder 104' (Fig. 8), läuft der Motor 11 mit seiner maximal möglichen Drehzahl.

Da die Schaltung nach Fig. 8 zu großen Teilen mit derjenigen nach Fig. 6 übereinstimmt, werden für gleiche oder gleichwirkende Teile dieselben Bezugszeichen verwendet wie dort. Abweichungen werden nachfolgend erläutert.

Bei Fig. 8 liegt in der Zuleitung zu den Motorwicklungen 12, 13 ein PTC-Widerstand 110, der den Motor 11 nach Art einer Sicherung vor Überlastung schützt. Ein gemeinsamer Emitterwiderstand für die Transistoren 30 und 38 ist im IC 95 nicht vorgesehen.

Statt des Widerstands 78 der Fig. 6 wird in Fig. 8 die Parallelschaltung von zwei Widerständen verwendet, nämlich eines äußeren Widerstandes 78' und eines inneren Widerstandes 78'' im IC 95, vgl. Fig. 9. Der Widerstand 77 der Fig. 6 befindet sich bei Fig. 8 im Inneren des IC 95, vgl. Fig. 9. Der Emitter des Transistors 80 und der eine Anschluß des Widerstands 78' sind deshalb an den Anschluß RT1 des IC 95 angeschlossen. Der Widerstand 83 der Fig. 6 ist ersetzt durch die Serienschaltung zweier Widerstände 83' und 83", deren Verbindungspunkt 111 mit dem Eingang V_{IN} des IC 95 verbunden ist.

Der Verbindungspunkt 82 des Widerstands 83' und des NTC-Widerstands 84 ist verbunden mit der Katode einer Zenerdiode 112, deren Anode mit der Basis eines npn-Transistors 114 verbunden ist, dessen Emitter mit dem Eingang RT2 und dessen Kollektor über einen Widerstand 115 mit der Plusleitung 18 verbunden ist.

Die Bauteile 112, 114, 115 stellen sicher, daß bei einer Unterbrechung einer Zuleitung zum NTC-Widerstand 84 an der Stelle 104 oder 104', der Motor 11 mit seiner maximalen Drehzahl läuft. In diesem Fall erhält nämlich der Knotenpunkt 82 ein so positives Potential, daß die Zenerdiode 112 leitend wird und den Transistor 114 leitend steuert. Dieser führt dem Eingang RT2 des IC 95 einen Basisstrom für einen dort befindlichen pnp-Transistor 116 (Fig. 9) zu, so daß dieser Transistor 116 voll leitend wird und die Widerstände 78' und 78'' kurzschließt. Dadurch wird das Potential am Verbindungspunkt 75 (Fig. 9) erheblich negativer, und dieses Signal bedeutet für den IC 95, daß der Motor 11 mit maximaler Drehzahl laufen soll, weshalb lange Stromimpulse i₁, i₂ gemäß Fig. 5b und Fig. 5c erzeugt werden.

Die beiden Ausgänge des Hallgenerators 21' sind mit den Eingängen IN+ und IN- des IC 95 verbunden. Der Eingang CT ist - wie in Fig. 9 - über einen Kondensator C2 mit der Minusleitung 19 und über einen Widerstand R2 mit dem Knotenpunkt 111 verbunden. Ein Glättungskondensator 120 liegt zwischen dem Knotenpunkt 111 und der Minusleitung 19.

Die Schaltung des Transistors 80 entspricht Fig. 6, d.h. seine Basis-Emitter-Strecke liegt in der Diagonalen der Brücke 85 zwischen den Knotenpunkten 75 (Fig. 9) entsprechend dem Eingang RT1, und dem Knotenpunkt 82. Auf diese Weise wird, wie bei Fig. 6 ausführlich beschrieben, verhindert, daß das Potential am Knotenpunkt 75, also am Eingang RT1, über einen vorgegebenen Wert ansteigen kann, z.B. über 4 V. Diese Spannung entspricht der Drehzahl nₘᵢₙ (Fig. 11), d.h. diese Drehzahl kann nicht unterschritten werden.

Bei zunehmenden Temperaturen entsprechend zunehmenden Drehzahlen n des Motors 11 nimmt der Widerstandswert des NTC-Widerstands 84 ab, wodurch der Transistor 80 stärker leitend wird und das Potential am Eingang RT1 absinkt, ebenso das Potential an der Basis des Transistors 73, so daß dieser weniger stark leitend wird und folglich die Spannung u₇₀ am Widerstand 70 absinkt. Dadurch werden, wie bei Fig. 6 ausführlich beschrieben, die Kondensatoren 42 und 45 schneller (über die Dioden 53 bzw. 54 und den Widerstand 70) entladen, wenn die Motordrehzahl n zunimmt, und folglich nimmt die Steilheit der Abschaltflanken 61,61' (Fig. 5) mit zunehmender Drehzahl n zu, ist aber niedrig bei niedrigen Drehzahlen, weshalb der so modifizierte Motor 11 bei niedrigen Drehzahlen sehr ruhig läuft.

Z.B. wird bei Fig. 8 die Drehzahl des Motors 11 gesteuert von der Temperatur am NTC-Widerstand 84, und diese Temperatur steuert auch die Flankensteilheit der Abschaltflanken 98, 98' (Fig. 10), d.h. diese Flankensteilheit ist eine (indirekte) Funktion der Drehzahl des Motors, entsprechend folgenden Zusammenhängen: Niedrige Drehzahl = niedrige Flankensteilheit; hohe Drehzahl = hohe Flankensteilheit. Statt einer solchen indirekten Steuerung wäre naturgemäß auch eine direkte Steuerung der Flankensteilheit durch die Drehzahl des Motors möglich, indem man z.B. in Fig. 8 der Basis des Transistors 73 ein drehzahlabhängiges Signal zuführte, d.h. dieser Transistor müßte bei niedrigen Drehzahlen einen hohen Basisstrom erhalten, damit die Spannung u₇₀ hoch wird und sich eine geringe Flankensteilheit der Abschaltflanken ergibt, dagegen bei hohen Drehzahlen einen niedrigen oder keinen Basisstrom, damit die Spannung u₇₀ niedrig wird und die Abschaltflanken steil werden. Das hierfür notwendige drehzahlabhängige Signal mit sehr geringer Welligkeit erfordert jedoch einen erheblichen Aufwand, während das Signal am NTC-Widerstand 84 bereits zur Verfügung steht, keine Welligkeit aufweist, und einfach zu verarbeiten ist. Naturgemäß könnten z.B. auch die Widerstände 43 und 46 abhängig von Drehzahl oder Temperatur verändert werden, sofern sie nicht - wie bei Fig. 8 - innerhalb eines IC angeordnet und daher nicht zugänglich sind.

Naturgemäß sind im Rahmen der vorliegenden Erfindung zahlreiche Abwandlungen und Modifikationen möglich.

## Patentansprüche

1. Elektronisch kommutierter Motor (11), insbesondere zum Antrieb eines Lüfters (15) mit variabler Drehzahl,
mit mindestens einem Wicklungsstrang (12, 13) und einem den Strom (i1, i2) in diesem Wicklungsstrang steuernden Halbleitersteuerglied (30, 38), welches eine Steuerelektrode und eine Ausgangselektrode aufweist, zwischen welchen die Serienschaltung eines Kondensators (42, 45) und eines Widerstands (43, 46) angeordnet ist,
und mit von einem Betriebsparameter des Motors abhängigen Steuermitteln, (58; 70), welche einen Lade- oder Entladevorgang des Kondensators (42, 45) dieser Serienschaltung temperatur- und/oder drehzahlabhängig beeinflussen, um die Flankensteilheit an den Abschaltflanken (Fig. 3: 49, 49') der durch diesen Wicklungsstrang (12, 13) fließenden Stromimpulse (i₁, i₂) so zu steuern, daß diese Flankensteilheit mit zunehmender Temperatur und/oder zunehmender Drehzahl zunimmt.

2. Motor nach Anspruch 1, bei welchem die Steuermittel (58; 70) über eine Diode (53, 54) an den Kondensator (42, 45) der Serienschaltung angeschlossen sind.

3. Motor nach Anspruch 2, welcher zwei Wicklungsstränge (12, 13) aufweist, denen jeweils ein Halbleitersteuerglied (30, 38) mit einer zwischen Steuerelektrode und Ausgangselektrode angeordneten Serienschaltung eines Kondensators (42, 45) und eines Widerstands (43, 46) zugeordnet ist, wobei die Steuermittel (58; 70) für beide Serienschaltungen gemeinsam sind und über eine erste Diode (53) an den Kondensator (42) der einen Serienschaltung (42, 43) und über eine zweite Diode (54) an den Kondensator (45) der anderen Serienschaltung (45, 46) angeschlossen sind.

4. Motor nach Anspruch 3, welcher als zweisträngiger, zweipulsiger Motor mit Reluktanz-Hilfmoment ausgebildet ist.

5. Motor nach einem oder mehreren der Ansprüche 1 bis 4, bei welchem die Steuermittel eine Stromsenke (Fig. 6 und 8: Punkt 71) mit einem Potential (u70) aufweisen, welches eine Funktion von Temperatur und/oder Motordrehzahl ist.

6. Motor nach einem oder mehreren der Ansprüche 1 bis 4, bei welchem die Steuermittel einen temperaturabhängigen Widerstand (Fig. 4: 58; Fig. 6, 7, 8: 84) aufweisen.

7. Motor nach Anspruch 6, bei welchem der temperaturabhängige Widerstand (Fig. 4: 58) in einem Entladekreis des Kondensators (42, 45) der mindestens einen Serienschaltung angeordnet ist.

8. Motor nach Anspruch 6 oder 7, bei welchem der temperaturabhängige Widerstand als NTC-Widerstand (58; 84) ausgebildet ist.

9. Motor nach einem oder mehreren der Ansprüche 6 bis 8, bei welchem der Widerstandswert des temperaturabhängigen Widerstands (84) die Drehzahl des Motors (11) bestimmt.

10. Motor nach einem oder mehreren der Ansprüche 6 bis 9, bei welchem Widerstandswerte des temperaturabhängigen Widerstands (84), welche außerhalb eines vorgegebenen Wertebereichs liegen, keinen zusätzlichen Einfluß auf Flankensteilheit und/oder Drehzahl des Motors (11) haben.

11. Motor nach Anspruch 10, bei welchem ein vom Widerstandswert des temperaturabhängigen Widerstands (84) abgeleitetes Signal hinsichtlich seines Wertes so begrenzt ist, daß es bei Überschreiten und/oder Unterschreiten eines vorgegebenen Widerstands-Grenzwertes keine zusätzliche Änderung erfährt.

12. Motor nach den Ansprüchen 5 und 6, bei welchem der temperaturabhängige Widerstand (84) Teil einer Brückenschaltung (85) ist, bei welcher die Spannung einer Brückendiagonale (75, 82) eine Anordnung (80) so steuert, daß bei Temperaturänderungen der Abgleich der Brücke (85) durch diese Anordnung (80) mindestens in einem vorgegebenen Temperaturbereich nachgeführt wird, und bei der die Spannung an einem der Brückenzweige (78) zur temperaturabhängigen Steuerung des Potentials (u70) der Stromsenke (Fig. 6 und 8: Punkt 71) dient.

13. Motor nach Anspruch 12, bei welchem die von der Spannung an der Brückendiagonalen (75, 82) gesteuerte Anordnung (80) so ausgebildet ist, daß bei sinkenden Temperaturen unterhalb einer vorgegebenen Temperatur (Fig. 11: theta1) die Nachführung des Abgleichs der Brücke beendet wird.

14. Motor nach Anspruch 12 oder 13, bei welchem der Brückenschaltung (85) eine Vorrichtung (112, 114, 115) zugeordnet ist, welche bei Unterbrechung (Fig. 8: 104, 104') einer Zuleitung zum temperaturäbhängigen Widerstand (84) durch ein dabei auftretendes Potential an einem Punkt (82) der Brückenschaltung (85) aktiviert wird und den Motor (11) auf eine hohe Drehzahl umschaltet (Fig. 8).

15. Elektronisch kommutierter Motor, insbesondere zum Antrieb eines Lüfters mit variabler Drehzahl,
mit einer Statorwicklungsanordnung (12, 13), welcher im Betrieb pro Rotordrehung von 360° el. mindestens zwei Stromimpulse (i₁, i₂) zugeführt werden, mit Flankensteuerungsmitteln (42, 43; 45, 46) zur Steuerung der Flankensteilheit an den Abschalfflanken (Fig. 3: 49, 49') dieser Stromimpulse,
und mit von der Temperatur der Leistungshalbleiter (30, 38) des Motors (11) abhängigen Steuermitteln (53, 54, 58; 70, 73, 74, 85), welche die Flankensteuerungsmittel so steuern, daß mit zunehmender Temperatur der Leistungshalbleiter (30, 38) die Flankensteilheit (Fig. 5: 61, 61') zunimmt.

## Claims

1. Electronically commutated motor (11), in particular for driving a fan (15) at variable speed, with at least one phase winding (12, 13) and a semiconductor control element (30, 38) which controls the current (i1, i2) in this phase winding and comprises a control electrode and an output electrode between which the series circuit of a capacitor (42, 45) and a resistor (43, 46) is disposed, and with control means (58; 70) which are dependent on an operating parameter of the motor and affect a process for charging or discharging the capacitor (42, 45) of this series circuit depending on temperature and/or speed in order to control the edge steepness at the switch-off edges (fig. 3: 49, 49') of the current pulses (i₁, i₂) flowing through this phase winding (12, 13) so that this edge steepness increases with increasing temperature and/or increasing speed.

2. Motor according to claim 1, in which the control means (58; 70) are connected by means of a diode (53, 54) to the capacitor (42, 45) of the series circuit.

3. Motor according to claim 2, which comprises two phase windings (12, 13) which are each associated with a semiconductor control element (30, 38) with a series circuit of a capacitor (42, 45) and a resistor (43, 46) disposed between the control electrode and the output electrode, whereby the control means (58; 70) are common to both series circuits and connected by means of a first diode (53) to the capacitor (42) of one series circuit (42, 43) and by means of a second diode (54) to the capacitor (45) of the other series circuit (45, 46).

4. Motor according to claim 3, which is embodied as an auxiliary reluctance torque motor with two phase windings operating on two pulses.

5. Motor according to one or more of claims 1 to 4, in which the control means comprise a current sink (figs. 6 and 8: item 71) with a potential (u70) which is a function of temperature and/or motor speed.

6. Motor according to one or more of claims 1 to 4, in which the control means comprise a temperature-dependent resistor (fig. 4: 58; figs. 6, 7, 8: 84).

7. Motor according to claim 6, in which the temperature-dependent resistor (fig. 4: 58) is disposed in a discharging circuit of the capacitor (42, 45) of the at least one series circuit.

8. Motor according to claim 6 or 7, in which the temperature-dependent resistor is embodied as an NTC resistor (58; 84).

9. Motor according to one or more of claims 6 to 8, in which the resistance value of the temperature-dependent resistor (84) determines the speed of the motor (11).

10. Motor according to one or more of claims 6 to 9, in which resistance values of the temperature-dependent resistor (84) lying outside a predetermined value range have no additional effect on edge steepness and/or speed of the motor (11).

11. Motor according to claim 10, in which a signal derived from the resistance value of the temperature-dependent resistor (84) is limited with regard to its value so that it undergoes no additional change when a predetermined resistance limit value is overshot and/or undershot.

12. Motor according to claims 5 and 6, in which the temperature-dependent resistor (84) is part of a bridge circuit (85) in which the voltage of a bridge diagonal (75, 82) controls an arrangement (80) so that when temperatures change the balance of the bridge (85) is tracked by this arrangement (80) at least in a predetermined temperature range, and in which the voltage at one of the bridge branches (78) serves for temperature-dependent control of the potential (u70) of the current sink (figs. 6 and 8: item 71).

13. Motor according to claim 12, in which the arrangement (80) controlled by the voltage at the bridge diagonal (75, 82) is embodied so that when temperatures fall below a predetermined temperature (fig. 11: theta 1) the tracking of the balance of the bridge is ended.

14. Motor according to claim 12 or 13, in which the bridge circuit (85) is associated with a device (112, 114, 115) which on disconnection (fig. 8: 104, 104') of a lead to the temperature-dependent resistor (84) is activated by a potential occurring at that time at a point (82) of the bridge circuit (85) and switches the motor (11) to a high speed (fig. 8).

15. Electronically commutated motor, in particular for driving a fan at variable speed, with a stator winding arrangement (12, 13) which when in operation is fed with at least two current pulses (i₁, i₂) for each revolution of the rotor of 360° el., with edge control means (42, 43; 45, 46) for controlling the edge steepness at the switch-off edges (fig. 3: 49, 49') of these current pulses, and with control means (53, 54, 58; 70, 73, 74, 85) which are dependent on the temperature of the power semiconductors (30, 38) of the motor (11) and control the edge control means so that the edge steepness (fig. 5: 61, 61') increases with increasing temperature of the power semiconductors (30, 38).

## Revendications

1. Moteur à commutation électronique (11), en particulier pour l'entraînement d'un ventilateur (15) à vitesse de rotation variable,
avec au moins un brin d'enroulement (12, 13) et un élément de commande semi-conducteur (30, 38), modulant le courant (il, i2) dans ce brin d'enroulement et présentant une électrode de commande et une électrode de sortie, entre lesquelles un condensateur (42, 45) et une résistance (43, 46) sont branchés en série,
et avec des moyens de commande (58 ; 70), dépendant d'un paramètre de fonctionnement du moteur, qui influent en fonction de la température et/ou de la vitesse de rotation sur le processus de chargement ou de déchargement du condensateur (42, 45) de ce branchement en série, pour commander la raideur de la pente de flanc de mise hors service (figure 3 : 49, 49') des impulsions de courant (i₁, i₂) passant par ce brin d'enroulement (12, 13), de manière que cette raideur de pente de flanc aille en augmentant lorsque la température et/ou la vitesse de rotation vont en augmentant.

2. Moteur selon la revendication 1, dans lequel les moyens de commande (58 ; 70) sont raccordés par une diode (53, 54) au condensateur (42, 45) du branchement série.

3. Moteur selon la revendication 2, présentant deux brins d'enroulement (12, 13) à chacun desquels est associé un organe de commande semi-conducteur (30, 38) équipé d'un branchement série, réalisé entre l'électrode de commande et l'électrode de sortie, d'un condensateur (42, 45) et d'une résistance (43, 46), les moyens de commande (58 ; 70) destinés aux deux branchements en série étant communs et étant raccordés, par l'intermédiaire d'une première diode (53), au condensateur (42) d'un premier branchement série (42, 43) et, par l'intermédiaire d'une deuxième diode (54), au condensateur (45) de l'autre branchement série (45, 46).

4. Moteur selon la revendication 3, réalisé sous la forme d'un moteur à deux impulsions, à deux brins, offrant un couple auxiliaire de réluctance.

5. Moteur selon l'une ou plusieurs des revendications 1 à 4, dans lequel les moyens de commande présentent un consommateur de courant (figures 6 et 8 ; point 71) ayant un potentiel (u70), qui est fonction de la température et/ou de la vitesse de rotation du moteur.

6. Moteur selon l'une ou plusieurs des revendications 1 à 4, pour lequel les moyens de commande présentent une résistance sensible à la température (figure 4 : 58 ; figures 6, 7, 8 : 84).

7. Moteur selon la revendication 6, pour lequel la résistance (figure 4 : 58) sensible à la température est disposée dans un circuit de décharge du condensateur (42, 45) de au moins un branchement série.

8. Moteur selon la revendication 6 ou 7, pour lequel la résistance sensible à la température est réalisée sous la forme d'une résistance NTC à coefficient de température négatif (58 ; 84).

9. Moteur selon l'une ou plusieurs des revendications 6 à 8, pour lequel le coefficient de résistance de la résistance (84) sensible à la température détermine la vitesse de rotation du moteur (11).

10. Moteur selon l'une ou plusieurs des revendications 6 à 9, pour lequel des coefficients de résistance de la résistance (84) sensible à la température, situés hors des limites d'une plage de valeurs prédéterminée, n'ont aucune influence additionnelle sur la raideur de la pente de flanc et/ou sur la vitesse de rotation du moteur (11).

11. Moteur selon la revendication 10, pour lequel un signal, dérivé de la valeur de la résistance (84) sensible à la température, est quantitativement limité, de manière que, en cas de franchissement par valeurs supérieures et/ou inférieures d'une valeur limite de résistance prédéterminée, il ne subisse aucune modification additionnelle.

12. Moteur selon les revendications 5 et 6, pour lequel la résistance (84) sensible à la température fait partie d'un circuit en pont (85) pour lequel la tension d'une diagonale de pont (75, 82) commande un dispositif (80), de manière que, en cas de fluctuations de la température, la compensation du pont (85) soit effectuée avec un effet de rattrapage par ce dispositif (80) au moins dans une plage de températures prédéterminée, et pour lequel la tension à l'une des branches de pont (78) sert à commander en fonction de la température le potentiel (u70) du consommateur de courant (figures 6 et 8 : point 71).

13. Moteur selon la revendication 12, pour lequel le dispositif (80) commandé par la tension des diagonales de pont (75, 82) est réalisé de manière que, en cas de baisse des températures au-dessous d'une température prédéterminée (figure 11 : theta 1), le rattrapage de la compensation des ponts soit achevé.

14. Moteur selon la revendication 12 ou 13, pour lequel au circuit à pont (85) est associé un dispositif (112, 114, 115) qui, en cas d'interruption (figure 8 : 104, 104') d'une ligne d'amenée allant à la résistance (84) sensible à la température, est activé par un potentiel se manifestant alors en un point (82) du circuit à pont (85) et commute le moteur (11) pour passer à une vitesse de rotation élevée (figure 8).

15. Moteur à commutation électronique, en particulier pour l'entraînement d'un ventilateur à vitesse de rotation variable,
avec un dispositif à enroulement de stator (12,13), auquel, en fonctionnement, sont amenées à chaque rotation de 360° du rotor au moins deux impulsions de courant (i₁, i₂), avec des moyens de commande de flancs (42, 43 ; 45, 46) destinés à commander la raideur de pente de flancs au niveau des flancs de mise hors service (figure 3 : 49, 49') de ces impulsions de courant, et avec des moyens de commande (53, 54, 58 ; 70, 73, 74, 85), sensibles à la température du semi-conducteur de puissance (30, 38) du moteur (11), qui commandent les moyens de commande de flancs de manière que, lorsque la température des semi-conducteurs de puissance (30, 38) augmente, la raideur de la pente des flancs (figure 5 : 61, 61') augmente.
